(19) Europäisches Patentamt
European Patent Office
Office européen des brevets

(11) EP 4 772 943 A1

(12) EUROPEAN PATENT APPLICATION
published in accordance with Art. 153(4) EPC

(43) Date of publication:
**08.07.2026 Bulletin 2026/28**

(21) Application number: **24859980.5**

(22) Date of filing: **30.08.2024**

(51) International Patent Classification (IPC):
***G03F 7/32*** *(2006.01)* ***C07C 211/63*** *(2006.01)*
***G03F 7/40*** *(2006.01)* ***H01L 21/027*** *(2006.01)*
***H01L 21/304*** *(2006.01)* ***H01L 21/306*** *(2006.01)*
***H01L 21/308*** *(2006.01)*

(52) Cooperative Patent Classification (CPC):
**C07C 211/63; G03F 7/32; G03F 7/40; H10P 50/00; H10P 50/691; H10P 52/00; H10P 76/00**

(86) International application number:
**PCT/JP2024/031289**

(87) International publication number:
**WO 2025/047955 (06.03.2025 Gazette 2025/10)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **01.09.2023 JP 2023142385**
**08.02.2024 JP 2024017580**
**10.05.2024 JP 2024077294**
**14.06.2024 JP 2024096739**

(71) Applicant: **TOKUYAMA CORPORATION**
**Yamaguchi 745-8648 (JP)**

(72) Inventors:
- **INOUE, Hiroshi**
  **Shunan-shi, Yamaguchi 745-8648 (JP)**
- **KAWABATA, Yuichiro**
  **Shunan-shi, Yamaguchi 745-8648 (JP)**

(74) Representative: **Hirons, Daniel Stuart**
**Withers & Rogers LLP**
**2 London Bridge**
**London SE1 9RA (GB)**

# (54) ALKALINE AQUEOUS SOLUTION FOR SEMICONDUCTOR, METHOD FOR USE AS LOW-TOXICITY ALKALINE AQUEOUS SOLUTION FOR SEMICONDUCTOR, AND METHOD FOR PRODUCING ALKALINE AQUEOUS SOLUTION FOR SEMICONDUCTOR

(57) An alkaline aqueous solution for a semiconductor, said solution comprising (A)-(D). (A) A quaternary ammonium ion represented by formula (1), (B) a halide ion, (C) a hydroxide ion, and (D) water (in the formula, $R^1$, $R^2$, $R^3$, and $R^4$ are each independently an alkyl group having 1-16 carbon atoms. However, the number of carbon atoms of one or more alkyl groups among $R^1$, $R^2$, $R^3$ and $R^4$ is 2-16.)

EP 4 772 943 A1

## Description

### Technical Field

The present invention relates to an aqueous alkali solution for semiconductors, a method for using the same as a low toxic aqueous alkali solution for semiconductors, and a method for manufacturing an aqueous alkali solution for semiconductors. More specifically, the present invention relates to an aqueous alkali solution for semiconductors containing a predetermined quaternary ammonium ion, a halide ion, a hydroxide ion, and water.

### Background Art

Quaternary ammonium compounds are used in phase transfer catalysts, surfactants, disinfectants and the like. Among the quaternary ammonium compounds, tetramethylammonium hydroxide is particularly used as a kind of strongly basic organic alkali in aqueous alkali solutions for semiconductors used in cleaning, etching, developers, and the like during semiconductor manufacturing.

For example, Patent Document 1 discloses a 2.35 wt.% aqueous tetramethylammonium hydroxide solution having a predetermined content of a metal ion and a halogen ion.

### Prior Art Documents

### Patent Document

Patent Document 1: JP H04-226466 A

### Summary of Invention

### Technical Problem

However, the present inventors have focused on the fact that an aqueous tetramethylammonium hydroxide (hereinafter also described as TMAH) solution is highly toxic and requires caution in handling.

Accordingly, an object of the present invention is to provide a low toxic aqueous alkali solution for semiconductors. Another object of the present invention is to provide a method for using the same as a low toxic aqueous alkali solution for semiconductors. Still another object of the present invention is to provide a method for manufacturing a low toxic aqueous alkali solution for semiconductors.

### Solution to Problem

The present inventors have conducted intensive studies to yield a low toxic aqueous alkali solution for semiconductors. As a result, the present inventors have found that an aqueous alkali solution for semiconductors containing a specific quaternary ammonium ion, a halide ion, a hydroxide ion, and water has low toxicity, and have completed the present invention.

That is, the configuration of the present invention is as follows.

Aspect 1: An aqueous alkali solution for semiconductors containing the following (A) to (D):

(A) a quaternary ammonium ion represented by Formula (1) below;
(B) a halide ion;
(C) a hydroxide ion; and
(D) water

[Chem 1]

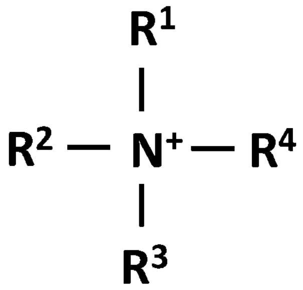

(1)

where $R^1$, $R^2$, $R^3$, and $R^4$ are each independently an alkyl group having carbon number from 1 to 16, with the proviso that the carbon number of one or more alkyl groups of $R^1$, $R^2$, $R^3$, and $R^4$ is from 2 to 16.

Aspect 2: The aqueous alkali solution for semiconductors according to Aspect 1, wherein $R^1$, $R^2$, $R^3$, and $R^4$ in Formula (1) are not all the same alkyl group.

Aspect 3: The aqueous alkali solution for semiconductors according to Aspect 1 or 2, wherein $R^1$, $R^2$, and $R^3$ in Formula (1) are methyl groups, and $R^4$ in Formula (1) is an alkyl group having carbon number from 2 to 16.

Aspect 4: The aqueous alkali solution for semiconductors according to any one of Aspects 1 to 3, wherein the halide ion (B) is a chloride ion or a bromide ion.

Aspect 5: The aqueous alkali solution for semiconductors according to any one of Aspects 1 to 4, wherein a part by mass of the halide ion is 0.0000001 to 0.01 parts by mass when a mass of the hydroxide ion in the aqueous alkali solution for semiconductors is 1 part by mass.

Aspect 6: The aqueous alkali solution for semiconductors according to any one of Aspects 1 to 5, wherein an LD50 value converted on the basis that a hydroxide of the quaternary ammonium ion is taken as 100 mass%, in a toxicity test using a rat based on an OECD TG420 acute oral toxicity test, is more than 50 mg/kg.

Aspect 7: The aqueous alkali solution for semiconductors according to any one of Aspects 1 to 6, wherein an EC50 value converted on the basis that a hydroxide of the quaternary ammonium ion is taken as 100 mass%, in an OECD TG202 Daphnia sp. acute immobilization test, is more than 3 mg/L.

Aspect 8: The aqueous alkali solution for semiconductors according to any one of Aspects 1 to 7, further containing one or more compounds selected from the group consisting of an alcohol and an amine.

Aspect 9: The aqueous alkali solution for semiconductors according to any one of Aspects 1 to 8, further containing a surfactant, wherein a concentration of the surfactant in the aqueous alkali solution for semiconductors is less than 100 mass ppm.

Aspect 10: A polishing composition containing the aqueous alkali solution for semiconductors according to any one of Aspects 1 to 9 and an abrasive grain.

Aspect 11: A method for using the aqueous alkali solution for semiconductors according to any one of Aspects 1 to 9 as a low toxic aqueous alkali solution for semiconductors.

Aspect 12: A method for manufacturing the aqueous alkali solution for semiconductors according to any one of Aspects 1 to 7, the method including an electrolysis step of electrolyzing an aqueous quaternary ammonium halide solution containing the following (A), (B), and (D):

(A) a quaternary ammonium ion represented by Formula (1) below;
(B) a halide ion; and
(D) water

[Chem2]

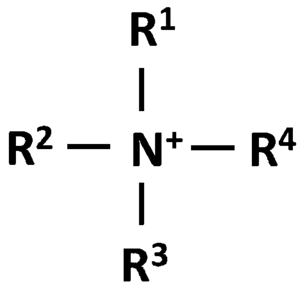

(1)

where $R^1$, $R^2$, $R^3$, and $R^4$ are each independently an alkyl group having carbon number from 1 to 16, with the proviso that the carbon number of one or more alkyl groups of $R^1$, $R^2$, $R^3$, and $R^4$ is from 2 to 16.

Aspect 13: The method for manufacturing the aqueous alkali solution for semiconductors according to Aspect 12, the method further including a preparation step of preparing the aqueous quaternary ammonium halide solution before the electrolysis step, wherein

the preparation step is a step of reacting a trialkylamine with an alkyl halide in ultrapure water to yield the aqueous quaternary ammonium halide solution.

Effects of Invention

According to the present invention, there is provided a low toxic aqueous alkali solution for semiconductors. As a result, an aqueous alkali solution for semiconductors is provided, which is highly safe in use and leads to a low environmental load. A method for using the aqueous alkali solution for semiconductors as a low toxic aqueous alkali solution for semiconductors is also provided. In addition, a method for manufacturing a low toxic aqueous alkali solution for semiconductors is provided.

Brief Description of Drawings

FIG. 1 is an explanatory view illustrating an electrolytic cell.

Description of Embodiments

Embodiments of the present invention are described in detail below, but as long as the gist of the present invention is observed, the present invention is not limited to the details described below. In addition, the present invention can be modified and implemented in any manner that does not depart from the gist of the present invention.

In the present specification, a numerical range expressed using the term "to" refers to a range including the numerical values described before and after "to" as the lower limit and the upper limit, respectively. Thus, the expression "A to B" means A or more and B or less. Further, when numerical ranges are described in a stepwise manner, the upper limit and the lower limit of each numerical range can be optionally combined.

An aqueous alkali solution for semiconductors according to an embodiment of the present invention contains the following (A) to (D):

(A) a quaternary ammonium ion represented by Formula (1) below;
(B) a halide ion;
(C) a hydroxide ion; and
(D) water

[Chem 3]

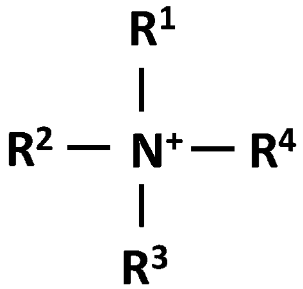

(1)

where $R^1$, $R^2$, $R^3$, and $R^4$ are each independently an alkyl group having carbon number from 1 to 16 (preferably from 1 to 8, and more preferably from 1 to 4), provided that one or more alkyl groups among $R^1$, $R^2$, $R^3$, and $R^4$ have carbon number from 2 to 16 (preferably from 2 to 8, and more preferably from 2 to 4).

The aqueous alkali solution for semiconductors contains the quaternary ammonium ion represented by Formula (1), and thus tends to have toxicity lower than that of an aqueous alkali solution for semiconductors using tetramethylammonium hydroxide.

In addition, the semiconductor treatment liquid contains the quaternary ammonium ion represented by Formula (1), and thus the etching rate can be improved. When the carbon numbers of $R^1$ to $R^4$ exceed the above range, the steric hindrance of the quaternary ammonium ion increases, and the etching rate may decrease. In addition, when the carbon numbers of $R^1$ to $R^4$ exceed the above range, the quaternary ammonium halide described below is less likely to be dissolved, which may make it difficult to manufacture the aqueous alkali solution for semiconductors.

In Formula (1), it is also preferable that $R^1$, $R^2$, $R^3$, and $R^4$ be not all the same alkyl group in terms of the low toxicity, etching rate, and ease of manufacturing the aqueous alkali solution for semiconductors. In other words, any one of quaternary ammonium ions represented by the following (1) to (3) is preferred:

(1) a quaternary ammonium ion in which any three of $R^1$, $R^2$, $R^3$, and $R^4$ are the same alkyl group, and the remaining one is an alkyl group different therefrom;
(2) a quaternary ammonium ion in which any two of $R^1$, $R^2$, $R^3$, and $R^4$ are the same alkyl group, and the remaining two are alkyl groups different therefrom (the remaining two can be the same or different); and
(3) a quaternary ammonium ion in which all of $R^1$, $R^2$, $R^3$, and $R^4$ are different alkyl groups.

In the case of the above (1), examples of the quaternary ammonium ion can include quaternary ammonium ions in which any three of $R^1$, $R^2$, $R^3$, and $R^4$ are the same alkyl group having carbon number from 1 to 16, the remaining one is an alkyl group having carbon number from 1 to 16, the first three and the remaining one are different alkyl groups, and either the first three or the remaining one has carbon number from 2 to 16. It is preferred that three of $R^1$, $R^2$, $R^3$, and $R^4$ in Formula (1) above be identical groups, and the remaining one be an alkyl group that has carbon number from 2 to 16 and is different from the three identical groups. In this case, the quaternary ammonium ion represented by Formula (1) has two types of alkyl groups. In this aspect, a quaternary ammonium ion in which any three of $R^1$, $R^2$, $R^3$, and $R^4$ are methyl groups and the remaining one alkyl group has carbon number from 2 to 16 is easy to serve as a surfactant described below. Among such quaternary ammonium ions, a quaternary ammonium ion in which the remaining one alkyl group has carbon number from 2 to 8 is more preferred, a quaternary ammonium ion in which the remaining one alkyl group has carbon number from 2 to 4 is still more preferred, and a quaternary ammonium ion in which the remaining one alkyl group has carbon number of 3 or 4 is most preferred.

In the case of the above (2), examples of the quaternary ammonium ion can include quaternary ammonium ions in which any two of $R^1$, $R^2$, $R^3$, and $R^4$ are the same alkyl group having carbon number from 1 to 16, the remaining two are alkyl groups having carbon number from 1 to 16, which is different from the first two, the remaining two are the same or different alkyl groups, and either the first two or the remaining two have carbon number from 2 to 16. In this case, the quaternary ammonium ion represented by Formula (1) has two or three types of alkyl groups. In this aspect, a quaternary ammonium ion in which any two of $R^1$, $R^2$, $R^3$, and $R^4$ are methyl groups, and the remaining two alkyl groups have carbon number from 2 to 16 is preferred. A compound in which any two of $R^1$, $R^2$, $R^3$, and $R^4$ are methyl groups is easy to serve as a surfactant described below. Among them, a quaternary ammonium ion in which the remaining two alkyl groups have carbon number from 2 to 8 is more preferred, a quaternary ammonium ion in which the remaining two alkyl groups have carbon number from 2 to 4 is still more preferred, and a quaternary ammonium ion in which the remaining two alkyl groups have carbon number of 3 or 4 is most preferred.

In the case of the above (3), examples of the quaternary ammonium ion can include a quaternary ammonium ion in which all of $R^1$, $R^2$, $R^3$, and $R^4$ are different alkyl groups, and at least one of them has carbon number from 2 to 16. In this case, the quaternary ammonium ion represented by Formula (1) has four types of alkyl groups. In this aspect, a quaternary ammonium ion in which any one of $R^1$, $R^2$, $R^3$, and $R^4$ is a methyl group, and the remaining three alkyl groups have carbon number from 2 to 16 is preferred. A compound in which any one of $R^1$, $R^2$, $R^3$, and $R^4$ is a methyl group is easy to serve as a surfactant described below. Among them, a quaternary ammonium ion in which the remaining three alkyl groups have carbon number from 2 to 8 is more preferred, a quaternary ammonium ion in which the remaining three alkyl groups have carbon number from 2 to 4 is still more preferred, and a quaternary ammonium ion in which the remaining three alkyl groups have carbon number of 3 or 4 is most preferred.

In Formula (1), all of $R^1$, $R^2$, $R^3$, and $R^4$ are optionally the same alkyl group. For example, all of $R^1$, $R^2$, $R^3$, and $R^4$ can be ethyl, propyl, or butyl.

Specific examples of the quaternary ammonium ion represented by Formula (1) include a tetraethylammonium ion, a tetrapropylammonium ion, a tetrabutylammonium ion, an ethyltrimethylammonium ion, a diethyldimethylammonium ion, a triethylmethylammonium ion, a propyltrimethylammonium ion, and a butyltrimethylammonium ion. One of the quaternary ammonium ions can be used, or a plurality thereof can be used.

The halide ion is not particularly limited, and specific examples thereof include one or more selected from the group consisting of a chloride ion, a bromide ion, and an iodide ion. In addition, a chloride ion or a bromide ion is preferred.

A part by mass of the halide ion when the mass of the hydroxide ion in the aqueous alkali solution for semiconductors is 1 part by mass is not particularly limited, but is preferably from 0.0000001 to 0.01 parts by mass, more preferably from 0.0000001 to 0.001 parts by mass, and still more preferably from 0.0000001 to 0.0005 parts by mass. The part by mass of the halide ion varies greatly depending on the method for manufacturing the aqueous alkali solution for semiconductors, and a solution having a reduced amount of halide ion can be prepared by using a manufacturing method by electrolysis in particular. The adjustment can be made by selecting the structure of a electrolytic cell and a cation exchange membrane used for electrolysis and changing conditions such as a current density.

When the part by mass of the halide ion is in the above range, in a case where the aqueous alkali solution for semiconductors is used as a semiconductor treatment liquid such as an etching liquid for silicon, a sufficient etching rate is maintained, and surface roughness due to etching is suppressed, which is desirable.

A substrate used for etching silicon can be any of a single crystal, a polycrystal, and amorphous, and an etching method is not particularly limited. As an example of the etching method, the aqueous alkali solution for semiconductors contains the quaternary ammonium ion represented by Formula (1), and the silicon substrate is immersed in the aqueous alkali solution for semiconductors for a predetermined time, for example, from 3 to 30 minutes, preferably from 5 to 15 minutes, whereby etching can be performed. The temperature of the etching method may be, for example, from 25 to 90°C, and preferably from 30 to 80°C.

The part by mass of the halide ion in the aqueous alkali solution for semiconductors can be analyzed by ion chromatography, and analysis by a neutralization method is particularly effective when the aqueous alkali solution has a high concentration. Specifically, before the aqueous alkali solution for semiconductors is introduced into the anion ion chromatography, cations in the aqueous alkali solution are exchanged with hydrogen ions to convert hydroxide ions into water. Thus, the hydroxide ions can be removed. Further, the sensitivity is enhanced by concentration. By using this method, it is possible to measure the concentration of a low-concentration halide ion. This will be described in detail below.

The aqueous alkali solution for semiconductors contains a hydroxide ion. The fact that the aqueous alkali solution for semiconductors contains the quaternary ammonium ion represented by Formula (1) and the hydroxide ion can also be said to indicate that the aqueous alkali solution for semiconductors contains a quaternary ammonium hydroxide containing the quaternary ammonium ion represented by Formula (1) and the hydroxide ion. The aqueous semiconductor alkali solution contains a quaternary ammonium hydroxide, and thus can be used as a treatment liquid during semiconductor manufacturing.

Concentrations of the quaternary ammonium ion represented by Formula (1) and the hydroxide ion in the aqueous alkali solution for semiconductors are not particularly limited, and an aqueous alkali solution for semiconductors containing a quaternary ammonium hydroxide at a concentration of from 1.0 to 65.0 mass% is preferably manufactured. In a case of being used for semiconductor applications, for example, the quaternary ammonium hydroxide is more preferably used at a concentration of from 1.0 to 10.0 mass%, and is still more preferably used at a concentration of from 2.0 to 7.0 mass%. The concentration is also preferably from 1.0 to 3.0 mass%, and particularly preferably 2.38 mass%.

The quaternary ammonium hydroxide is preferably used at a molarity of from 0.10 to 0.50 mol/L, and is more preferably used at a molarity of from 0.15 to 0.35 mol/L.

Further, high-concentration quaternary ammonium hydroxide can be diluted to be used. With the high concentration, the volume during transportation can be reduced, which can suppress the transportation cost. Even when the aqueous alkali solution for semiconductors is contaminated when it is filled in a container or transported, the influence of contamination can be reduced by the extent of dilution, as compared with a case where the dilution is not performed. The concentration of the high-concentration quaternary ammonium hydroxide is preferably from 10.0 to 50.0 mass%, and

more preferably from 20.0 to 40.0 mass%. The concentration of the quaternary ammonium hydroxide can be confirmed by neutralization titration with an acid or the like.

The concentration of the quaternary ammonium ion represented by Formula (1) in the aqueous alkali solution for semiconductors is preferably from 0.8 to 61.7 mass%. In addition, the concentration is more preferably from 0.8 to 9.5 mass%, and still more preferably from 1.2 to 6.7 mass%. The concentration of the quaternary ammonium ion in the high-concentration quaternary ammonium hydroxide before dilution is preferably from 8.0 to 47.5 mass%, and more preferably 16.0 to 38.0 mass%.

The concentration of the hydroxide ion in the aqueous alkali solution for semiconductors is preferably from 0.05 to 10.6 mass%. In addition, the concentration is more preferably from 0.05 to 1.6 mass%, and still more preferably from 0.1 to 1.2 mass%. The concentration of the hydroxide ion in the high-concentration quaternary ammonium hydroxide is preferably from 0.5 to 8.0 mass%, and more preferably from 1.0 to 6.4 mass%.

The aqueous alkali solution for semiconductors contains water. A form of water is not particularly limited. Known water can optionally be used, and it is particularly preferable that the water be ultrapure water in which metal impurities are decreased. The content of water in the aqueous alkali solution for semiconductors is not particularly limited, but is preferably from 90.0 to 99.0 mass%, more preferably from 93.0 to 98.0 mass%, and still more preferably from 97.0 to 98.0 mass%.

The aqueous alkali solution for semiconductors can contain one or more compounds selected from the group consisting of an alcohol and an amine. A concentration of the one or more compounds selected from the group consisting of an alcohol and an amine in the aqueous alkali solution for semiconductors is not particularly limited, but is preferably from 0.1 to 10000 mass ppm, and more preferably from 0.1 to 100 mass ppm.

The alcohol is not particularly limited, and a known alcohol can be used. Examples of the alcohol include primary alcohols such as methanol, ethanol, and 1-propanol, secondary alcohols such as 2-propanol and 2-butanol, and tertiary alcohols such as 2-methyl-2-propanol. The number of hydroxyl groups in the alcohol is not particularly limited, and a monohydric alcohol can be used, or a dihydric or higher alcohol can be used. Among them, an alcohol having carbon number of 16 or less (more preferably carbon number from 2 to 8, and still more preferably carbon number from 2 to 4) is preferred from the viewpoint of increasing the possibility of causing adsorption inhibition or the like during semiconductor treatment when the alcohol has a long chain.

The amine is not particularly limited, and a known amine can be used. Examples of the amine include primary amines such as methylamine, secondary amines such as dimethylamine, and tertiary amines such as trimethylamine. The number of amino groups in the amine is not particularly limited, and a monoamine can be used, or a diamine or higher amine can be used. Among them, an amine having carbon number of 16 or less (more preferably carbon number from 2 to 8, and still more preferably carbon number from 2 to 4) is preferred from the viewpoint that the amine having a long chain increases the possibility of causing adsorption inhibition or the like during semiconductor treatment.

The aqueous alkali solution for semiconductors can contain a surfactant. The concentration of the surfactant in the aqueous alkali solution for semiconductors is preferably less than 100 mass ppm. The semiconductor treatment liquid does not need to include a surfactant.

The quaternary ammonium ion represented by Formula (1) contained in the aqueous alkali solution for semiconductors is asymmetric with respect to the nitrogen atom as the center, and one or more alkyl groups of $R^1$, $R^2$, $R^3$, and $R^4$ have carbon number from 2 to 16, and thus, it is considered that the quaternary ammonium ion itself also serves as a surfactant. Specifically, a portion of the alkyl group having large carbon number becomes lipophilic, and a portion having small carbon number becomes hydrophilic. Accordingly, the quaternary ammonium ion represented by Formula (1) has a lipophilic moiety and a hydrophilic moiety in the ion structure, and is considered to serve as a surfactant. Thus, the aqueous alkali solution for semiconductors does not need to contain a surfactant at all, and even when it contains a surfactant, the concentration thereof can be as low as less than 100 mass ppm. The concentration of the surfactant is more preferably less than 50 mass ppm, still more preferably less than 30 mass ppm, and particularly preferably less than 10 mass ppm. When the aqueous alkali solution for semiconductors does not contain a surfactant, or when the concentration thereof is less than 100 mass ppm even if it contains a surfactant, for example, foaming of the aqueous alkali solution for semiconductors can be suppressed, and impurities derived from the surfactant can be suppressed. In addition, in a case where the quaternary ammonium hydroxide is recovered from the used aqueous alkali solution for semiconductors by separation, purification, or the like and is repeatedly used, it is necessary to add the surfactant again in a case where the surfactant is required as the aqueous alkali solution for semiconductors.
However, in a case where the surfactant is not required to be contained, the recovered liquid can be used as it is as the aqueous alkali solution for semiconductors, and when a low concentration of the surfactant is sufficient, the amount of the surfactant to be added again can be suppressed, which is preferable. The lower limit of the surfactant is not particularly defined, but for exhibiting the above effect, the surfactant is preferably contained in an amount of 0.01 mass ppm or more, and more preferably 0.1 mass ppm or more.

The surfactant is a compound having a hydrophilic group and a hydrophobic group (lipophilic group) in one molecule, and examples thereof include a nonionic surfactant, an anionic surfactant, a cationic surfactant, and an

amphoteric surfactant.

Note that the surfactant is a compound different from the compound containing the above-described quaternary ammonium ion that can be contained in the aqueous alkali solution for semiconductors.

As evaluation of the toxicity of an aqueous alkali solution for semiconductors, a median lethal dose (LD50) value converted on the basis that a hydroxide of a quaternary ammonium ion is taken as 100 mass%, in a toxicity test using a rat based on an acute oral toxicity test in accordance with OECD Test Guideline 420, is preferably more than 50 mg/kg. This makes the safety in use higher. In addition, in the GHS classification, in a case where the LD50 value is 50 mg/kg or less, it falls under Category 2, and regulations in storage, transportation, and the like are strict, and in a case where the LD50 value is 5 mg/kg or less, it falls under Category 1, and the regulations are further strict. Thus, the LD50 value is preferably more than 50 mg/kg. The upper limit of the LD50 value is not particularly limited, but is more preferably more than 50 mg/kg and 10000 mg/kg or less, and still more preferably more than 300 mg/kg and 10000 mg/kg or less.

The LD50 value can be adjusted by changing the type of the quaternary ammonium ion represented by Formula (1).

As evaluation of the toxicity of an aqueous alkali solution for semiconductors, a 50% effective concentration (EC50) value converted assuming that a hydroxide of a quaternary ammonium ion is taken as 100 mass%, in an OECD TG202 Daphnia sp. acute immobilization test, is preferably more than 3 mg/L. This makes the environmental load easy to be reduced. The EC50 value of TMAH, which is highly toxic and is likely to cause an environmental load, is 3 mg/L, and is preferably higher than 3 mg/L from the viewpoint of reducing an environmental load. The upper limit of the EC50 value is not particularly limited, but is more preferably more than 3 mg/L and 1000 mg/L or less, and still more preferably more than 10 mg/L and 1000 mg/L or less.

The EC50 value can be adjusted by changing the type of the quaternary ammonium ion represented by Formula (1).

In view of the toxicities obtained in the TG420 acute oral toxicity test and the TG202 Daphnia sp. acute immobilization test of OECD, for example, in Formula (1), a quaternary ammonium ion in which $R^1$, $R^2$, and $R^3$ are alkyl groups having carbon number of 1, and $R^4$ is an alkyl group having carbon number from 2 to 4, a quaternary ammonium ion in which $R^1$, $R^2$, $R^3$, and $R^4$ are alkyl groups having carbon number of 2, a quaternary ammonium ion in which $R^1$, $R^2$, $R^3$, and $R^4$ are alkyl groups having carbon number of 3, a quaternary ammonium ion in which $R^1$, $R^2$, $R^3$, and $R^4$ are alkyl groups having carbon number of 4, or the like is preferably used. More specifically, an ethyltrimethylammonium ion, a propyltrimethylammonium ion, a butyltrimethylammonium ion, a tetraethylammonium ion, a tetrapropylammonium ion, and a tetrabutylammonium ion are preferred.

The aqueous alkali solution for semiconductors can be used as a treatment liquid in semiconductor manufacturing, such as an etching liquid, a cleaning liquid, or a developer. That is, the aqueous alkali solution of the present invention can be used for manufacturing a semiconductor.

The aqueous alkali solution for semiconductors can be used as a low toxic aqueous alkali solution for semiconductors. That is, one aspect of the present invention is a method of using the aqueous alkali solution for semiconductors of the present invention as a low toxic aqueous alkali solution for semiconductors.

In another embodiment of the aqueous alkali solution for semiconductors of the present invention, the aqueous alkali solution for semiconductors can be used as a constituent component of a chemical mechanical polishing (CMP) composition (polishing composition). Inorganic bases such as sodium hydroxide and potassium hydroxide, which have been generally used, have a concern of contamination of metal ions during use, while tetramethylammonium hydroxide (TMAH), which is an organic base, is highly toxic, and thus has strict regulations during storage and transportation, and has a large environmental load in terms of waste liquid treatment after use. In contrast, the aqueous alkali solution for semiconductors of the present invention has low toxicity, and thus, when a polishing composition using the same is prepared and used, the above problems are less likely to occur.

The polishing composition of the present embodiment contains the aqueous alkali solution for semiconductors and an abrasive grain.

As conditions of the aqueous alkali solution for semiconductors used in the polishing composition of the present embodiment, those described above can be used as they are. A preferable quaternary ammonium ion represented by Formula (1) has two types of alkyl groups. In this aspect, a quaternary ammonium ion in which any three of $R^1$, $R^2$, $R^3$, and $R^4$ in Formula (1) are methyl groups and the remaining one alkyl group has carbon number from 2 to 16 can prepare a low toxic polishing composition. In addition, the prepared polishing composition exhibits a favorable polishing rate and provides a good appearance after polishing. Among them, a quaternary ammonium ion in which the remaining one alkyl group has carbon number from 2 to 8 is more preferred, a quaternary ammonium ion in which the remaining one alkyl group has carbon number of 2, 3, or 4 is still more preferred, and a quaternary ammonium ion in which the remaining one alkyl group has carbon number of 3 or 4 is most preferred. Two or more quaternary ammonium ions represented by Formula (1) can be used in combination, and examples of the preferred combination include a combination of an ethyltrimethylammonium ion and a propyltrimethylammonium ion, and a combination of an ethyltrimethylammonium ion and a butyltrimethylammonium ion. These combinations can be further combined with another quaternary ammonium ion represented by Formula (1).

The part by mass of the hydroxide having a quaternary ammonium ion contained in the aqueous alkali solution for semiconductors used in the polishing composition of the present embodiment is not particularly limited, but in the polishing composition, the concentration and the mixing amount of the aqueous alkali solution for semiconductors are preferably adjusted in such a manner that the hydroxide of the quaternary ammonium ion represented by Formula (1) is usually 0.0001 to 15 parts by mass, preferably 0.005 to 10 parts by mass, and more preferably 0.01 to 5 parts by mass.

The part by mass of the halide ion contained in the aqueous alkali solution for semiconductors used in the polishing composition of the present embodiment is not particularly limited, but is 0.0000001 to 0.01 parts by mass, more preferably 0.0000001 to 0.001 parts by mass, and still more preferably 0.0000001 to 0.0005 parts by mass with respect to 1 part by mass of the hydroxide ion, and contamination of an object to be polished during CMP processing can also be reduced.

The range of pH (25°C) of the polishing composition only needs to be appropriately selected depending on the intended use and is not limited, but for example, in the polishing application of a silicon wafer, the polishing composition can be used at usually 8 to 12, and preferably 9 to 11, and for example, the pH of a polishing liquid composition containing an oxidizing agent can be used at usually 1 to 8, and preferably 2 to 7.

The polishing composition of the present embodiment contains an abrasive grain, and examples of the abrasive grain that can be used in the aqueous polishing composition include an inorganic particle, an organic particle, and an organic-inorganic composite particle. Examples of the inorganic particle include silicon dioxide, aluminum oxide, cerium oxide, titanium oxide, silicon nitride, and zirconium oxide. Among these, as silicon dioxide, fumed silica, colloidal silica, and the like can be used. Examples of the organic particle include a styrene-based copolymer, a (meth)acrylic copolymer, and a polyimide-based particle. As these abrasive grains, a known material can be used as appropriate. The average particle size of the abrasive grains can be appropriately selected depending on the application and is not particularly limited, but the average primary particle size can be, for example, from 10 to 50 nm, and preferably from 20 to 40 nm. The average primary particle size of the abrasive grains can be calculated from the specific surface area S ($m^2/g$) measured by the BET method, for example, by the equation of average primary particle diameter (nm) = 2727/S. The specific surface area of the abrasive grain can be measured using, for example, a surface area measuring device, product name "Flow Sorb II 2300" available from Micromeritics Instrument Corporation. The average secondary particle size of the abrasive grains can be, for example, from 10 to 200 nm, and preferably from 20 to 150 nm. The average secondary particle size of the abrasive grains can be measured as a volume average particle size by a dynamic light scattering method using, for example, a model "UPA-UT151" available from Nikkiso Co., Ltd.

The blending amount of the abrasive grains in the polishing composition of the present embodiment is not particularly limited, but is, for example, from 0.01 to 20 mass%, preferably from 0.03 to 15 mass%, and more preferably from 0.05 to 10 mass% with respect to the polishing composition.

The polishing composition of the present embodiment can contain an oxidizing agent, a chelating agent, a surfactant, a water-soluble compound, and the like, as necessary.

Examples of the oxidizing agent include hydrogen peroxide, peracetic acid, perbenzoic acid, perchloric acid, an organic peroxide, a nitric acid compound, a persulfate, salts of polyvalent metals such as cerium ammonium nitrate, and heteropolyacids such as silicotungstic acid and silicomolybdic acid, and these may be used alone or in combination of two or more. In a case where the polishing composition of the present embodiment contains an oxidizing agent, the blending amount of the oxidizing agent in the polishing composition is not particularly limited, but is, for example, from 0.001 to 50 mass%, preferably from 0.01 to 30 mass%, and more preferably from 0.05 to 25 mass% with respect to the polishing composition.

Examples of the chelating agent include aminocarboxylic acid-based and phosphonic acid-based chelating agents.

Examples of the surfactant include the nonionic surfactant, the anionic surfactant, the cationic surfactant, and the amphoteric surfactant described above, and these surfactants may be used alone or in combination of two or more thereof. In a case where the polishing composition of the present embodiment contains an oxidizing agent, the blending amount of the chelating agent in the polishing composition is not particularly limited, but is, for example, from 0.0001 to 1 mass%, preferably from 0.001 to 0.5 mass%, and more preferably from 0.005 to 0.1 mass% with respect to the polishing composition.

Examples of the water-soluble compound include hydroxyethylcellulose, carboxymethylcellulose, hydroxyethylcellulose, glycerin, polyglycerin, polyvinyl alcohol, and polyethylene glycol, and these compounds may be used alone or in combination of two or more thereof. In a case where the polishing composition of the present embodiment contains a water-soluble compound, the blending amount of the water-soluble compound in the polishing composition is not particularly limited, but is, for example, from 0.001 to 10 mass% of the polishing composition, preferably from 0.003 to 3 mass%, and more preferably from 0.005 to 0.5 mass%.

The polishing composition of the present embodiment contains the aqueous alkali solution for semiconductors and the abrasive grain, and the remainder other than the abrasive grain, the components described above, and another

optional additive in the polishing composition is the aqueous alkali solution for semiconductors. The polishing composition of the present embodiment can be used as it is, or can be used after diluting a once prepared polishing composition with water.

The wafer to which the polishing composition of the present embodiment can be applied is not particularly limited, and examples thereof include a silicon wafer, a SiC wafer, a GaN wafer, a GaAs wafer, a GaP wafer, a glass wafer, an aluminum wafer, and a sapphire wafer.

A method for manufacturing an aqueous alkali solution for semiconductors is not particularly limited, but from the viewpoint of suppressing the halide ion concentration, it is preferable to yield an aqueous alkali solution for semiconductors by electrolyzing an aqueous quaternary ammonium halide solution. That is, the method preferably includes an electrolysis step of electrolyzing the aqueous quaternary ammonium halide solution. Specifically, the method preferably includes an electrolysis step of electrolyzing an aqueous quaternary ammonium halide solution containing the following (A), (B), and (D). (A), (B), and (D) as described above can be used:

(A) a quaternary ammonium ion represented by Formula (1) below;
(B) a halide ion; and
(D) water

[Chem 4]

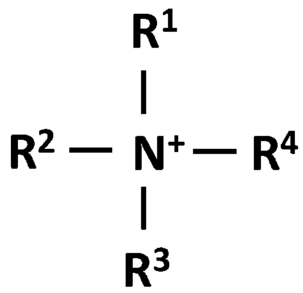

(1)

where $R^1$, $R^2$, $R^3$, and $R^4$ are each independently an alkyl group having carbon number from 1 to 16 (preferably from 1 to 8, and more preferably from 1 to 4), provided that one or more alkyl groups among $R^1$, $R^2$, $R^3$, and $R^4$ have carbon number from 2 to 16 (preferably from 2 to 8, and more preferably from 2 to 4).

The manufacturing of the aqueous alkali solution for semiconductors by electrolysis can be performed by using an electrolytic cell in which one or more cation exchange membranes are disposed between an anode and a cathode and which is provided with a raw material chamber for supplying an aqueous quaternary ammonium halide solution as a raw material and a base chamber (cathode chamber) in which an aqueous quaternary ammonium hydroxide solution is produced. In the manufacturing method using this electrolytic cell, quaternary ammonium ions contained in the aqueous quaternary ammonium halide solution pass through the cation exchange membrane disposed on the cathode side during electrolysis. As a result, an aqueous quaternary ammonium hydroxide solution is produced in the base chamber.

The above example is an example in which one or more cation exchange membranes are disposed. However, an electrolytic cell in which a plurality of membranes selected from the group consisting of a cation exchange membrane, an anion exchange membrane, and a bipolar membrane (a composite membrane composed of a cation exchange membrane and an anion exchange membrane) are disposed can be used as long as an aqueous quaternary ammonium hydroxide solution can be produced.

At this time, a halide ion which is an anion of the quaternary ammonium halide moves to the anode side, but a part of the halide ion also moves to the cathode side by diffusion. Therefore, depending on the concentration of the liquid used as the raw material, about from 1 to several tens ppm of halide ions may be mixed into the aqueous quaternary ammonium hydroxide solution.

The method for manufacturing an aqueous alkali solution for semiconductors can include, before the electrolysis step, a preparation step of preparing an aqueous quaternary ammonium halide solution to be used as a raw material in the electrolysis step.

The preparation step is not particularly limited. For example, an aqueous quaternary ammonium halide solution can be prepared by manufacturing an aqueous quaternary ammonium halide solution. A method for manufacturing the aqueous quaternary ammonium halide solution is not particularly limited. For example, from the viewpoint of productivity and quality, it is preferably a step of producing a quaternary ammonium halide by reacting a trialkylamine with an alkyl halide in ultrapure water.

The trialkylamine and the alkyl halide used as raw materials are not particularly limited as long as the quaternary ammonium ion represented by Formula (1) can be produced. Specifically, among the alkyl groups contained in the trialkylamine and the alkyl groups contained in the alkyl halide, one or more alkyl groups are alkyl groups having carbon number from 2 to 16 (preferably from 2 to 8, and more preferably from 2 to 4), and the other alkyl groups are alkyl groups having carbon number from 1 to 16 (preferably from 1 to 8, and more preferably from 1 to 4).
The halide ion which is an anion of an alkyl halide can be the same as (B) described above.
Since impurities contained in the quaternary ammonium halide are also diffused and mixed into the aqueous quaternary ammonium hydroxide solution, it is preferable to use a highly pure quaternary ammonium halide. Specifically, the concentration of the alcohol in the aqueous quaternary ammonium halide solution is preferably from 0.1 to 10000 mass ppm, and the concentration of the amine is preferably from 0.1 to 10000 mass ppm.

Examples

Hereinafter, to specifically describe the present invention, examples will be shown, but the present invention is not limited to these examples. The evaluations performed in Examples and Comparative Examples were determined by the following methods.

(Examples 1 to 13 and Comparative Example 1)

[Aqueous Alkali Solution for Semiconductors]

An aqueous quaternary ammonium hydroxide solution was prepared to have the concentration shown in Table 1, and various evaluations were performed.

- Ethyltrimethylammonium hydroxide (ETMAH, made from raw materials)
- Diethyldimethylammonium hydroxide (DEDMAH, available from Sigma-Aldrich)
- Propyltrimethylammonium hydroxide (PTMAH, made from raw materials)
- Butyltrimethylammonium hydroxide (BTMAH, made from raw materials)
- Tetraethylammonium hydroxide (TEAH, available from Tokyo Chemical Industry Co., Ltd.)
- Tetrapropylammonium hydroxide (TPAH, available from Tokyo Chemical Industry Co., Ltd.)
- Tetrabutylammonium hydroxide (TBAH, available from Tokyo Chemical Industry Co., Ltd.)
- Hexadecyltrimethylammonium hydroxide (HTMAH, available from Tokyo Chemical Industry Co., Ltd.)
- Tetramethylammonium hydroxide (TMAH, available from Tokuyama Corporation)

[Surfactant]

- SURFYNOL (trade name) 465 (available from Nisshin Chemical Industry Co., Ltd.)

[Preparation of Aqueous Quaternary Ammonium Hydroxide Solution]

ETMAH, PTMAH, and BTMAH were prepared by the following procedure. An aqueous quaternary ammonium halide solution was produced from a trialkylamine and an alkyl halide as raw materials, and an aqueous quaternary ammonium hydroxide solution was produced by electrolysis using the aqueous quaternary ammonium halide solution as a raw material. Specifically, in the case of ETMAH, trimethylamine and ethyl chloride at a molar ratio of 1:1 were put into a reaction vessel containing ultrapure water, which were retained at a reaction temperature of 60°C to produce a 50 mass% aqueous ethyltrimethylammonium chloride solution. Trimethylamine and ethyl chloride, which were unreacted components, and ethanol, which was a by-product, were each removed under reduced pressure until the amounts thereof were each less than 100 ppm, and then ETMAH was produced using the electrolytic cell shown in FIG. 1. In FIG. 1, 1 denotes an anode, 2 denotes a cathode, 3 denotes a power supply, 4 denotes an anode chamber, 5 denotes a raw material chamber, 6 denotes an intermediate chamber, 7 denotes a cathode chamber, 8 denotes an anion exchange membrane, and 9 denotes a cation exchange membrane.
A platinum-plated nickel plate was used as the cathode, a platinum-plated titanium plate was used as the anode, two sheets of Nafion N324 (available from The Chemours Company) were used as the cation exchange membrane, and ASE (available from ASTOM CORPORATION) was used as the anion exchange membrane. Electrolysis was continuously carried out while gradually increasing the current density and finally maintaining the current density at 30 $A/dm^2$ and the temperature at 40°C, by circulating 0.5 N hydrochloric acid in the anode chamber, a 50 mass% aqueous

ethyltrimethylammonium chloride solution in the raw material chamber between the anion exchange membrane and the cathode-side cation exchange membrane, and ultrapure water in the intermediate chamber between the cathode chamber and the two cation exchange membranes. During the electrolysis, the aqueous ethyltrimethylammonium chloride solution was replenished, and the concentration of ethyltrimethylammonium chloride in the raw material chamber was maintained at 40 mass% or more. When the concentration of ETMAH in the cathode chamber increased to 30 mass%, the electrolysis was terminated, resulting in the formation of an aqueous ETMAH solution. This aqueous ETMAH solution was diluted with ultrapure water and used in Examples 1, 2, 12, and 13 at the concentrations shown in Table 1.

PTMAH and BTMAH were produced in the same manner as in the production of ETMAH except that propyl chloride and butyl chloride were used as alkyl halides, respectively.

ETMAH used in Example 3 was obtained in the same manner as in the preparation of ETMAH used in Examples 1, 2, 12, 13, and 14 except that the number of cation exchange membranes in FIG. 1 was reduced from two to one and an electrolytic cell without an intermediate chamber was used. The surfactant shown in Table 1 was added in Examples 14 to 16 and Comparative Example 2.

The concentrations of the amines in the aqueous alkali solutions of Examples 1 to 16 and Comparative Examples 1 and 2 were all less than 100 mass ppm. Further, the concentrations of the alcohols in the aqueous alkali solutions of Examples 1 to 16 and Comparative Examples 1 and 2 were all less than 100 mass ppm.

[Evaluation Method]

1) Measurement of Halide Ion Concentration

In a case where the quaternary ammonium hydroxide concentration of the aqueous alkali solution for semiconductors was 5 mass% or less, the aqueous alkali solution for semiconductors was allowed to pass through an Ongard Cartridge IIH+ type 2.5 cc (available from Thermo Fisher Scientific Inc.) as it was, and in a case where the concentration exceeded 5 mass%, the aqueous alkali solution for semiconductors was diluted with ultrapure water to 5 mass% and allowed to pass through the Ongard Cartridge IIH+ type 2.5 cc. Thereafter, the liquid was recovered, and anion analysis of the recovered liquid was performed by an ion chromatograph (Integrion, available from Thermo Fisher Scientific Inc.) to determine a halide ion concentration.

2) Hydroxide Ion Concentration

One mL of each of the aqueous solutions prepared in Examples and Comparative Examples was subjected to neutralization titration with 0.1 mol/L hydrochloric acid using a Hiranuma automatic titrator (COM-1700, available from HIRANUMA). The hydroxide ion concentration of the aqueous alkali solution for semiconductors was determined from the liquid amount of 0.1 mol/L hydrochloric acid required for neutralization.

3) Acute Oral Toxicity

Data of the median lethal dose (LD50) in a toxicity test using a rat was collected. The aqueous quaternary ammonium hydroxide solutions for which no data was disclosed were subjected to a toxicity test based on the OECD TG420 acute oral toxicity to acquire data.

The obtained median lethal dose was converted to 100 mass% of the quaternary ammonium hydroxide aqueous solution, and evaluation was performed based on the following criteria. In a case where two or more types of quaternary ammonium hydroxide aqueous solutions were mixed, the median lethal dose of each quaternary ammonium hydroxide aqueous solution was multiplied by the mixing ratio, and the sum of the resulting values was determined. The results are shown in Table 1.

A: Median lethal dose of more than 300 mg/kg
B: Median lethal dose of more than 50 mg/kg to 300 mg/kg or less
C: Median lethal dose of 50 mg/kg or less

The low toxic aqueous alkali solution for semiconductors is preferably evaluated as A to B, and more preferably evaluated as A.

4) Ecotoxicity (Acute)

Data were collected for the 50% effective concentration (EC50) in the Daphnia sp. acute immobilization test. The aqueous quaternary ammonium hydroxide solutions for which no data was disclosed were subjected to a toxicity test

based on the OECD TG202 Daphnia sp. acute immobilization test to acquire data.

The obtained median lethal dose was converted to 100 mass% of the aqueous quaternary ammonium hydroxide solution, and evaluation was performed based on the following criteria. In a case where two or more types of aqueous quaternary ammonium hydroxide solutions were mixed, the median lethal dose of each aqueous quaternary ammonium hydroxide solution was multiplied by the mixing ratio, and the sum of the resulting values was determined. The results are shown in Table 1.

A: 50% effective concentration of more than 10 mg/L
B: 50% effective concentration of more than 3 mg/L to 10 mg/L or less
C: 50% effective concentration of 3 mg/L or less

The aqueous alkali solution for semiconductors evaluated as A or B can be said to be a low toxic aqueous alkali solution for semiconductors, and is preferably evaluated as A.

In addition, even when the ecotoxicity is evaluated as C, if the acute oral toxicity is evaluated as A to B, the aqueous solution can be evaluated as low toxicity.

5) Development Test

4-inch silicon wafers were prepared, and the surfaces thereof were washed with sulfuric acid-hydrogen peroxide (volume ratio: 4 : 1). The silicon wafers were baked on a hot plate at 200°C for 60 seconds. Then, a positive photoresist was applied to the silicon wafers using a spinner to yield positive photoresist films each having a thickness of 3.5 μm. Next, these photoresist films were irradiated with g-, h-, and i-rays having a wavelength of 300 to 500 μm through a mask pattern, and then various aqueous alkali solutions for semiconductors were dropped thereon. The development time was set to 8 minutes or 12 minutes, and the resist films were left to stand at 23°C, then washed with ultrapure water, and dried to yield a 20 μm contact hole pattern.

The presence or absence of scum and the shape of the obtained resist pattern were confirmed by SEM, and evaluation was performed based on the following criteria. The results are shown in Table 2.

A: No scum is generated in both cases of the development time of 8 minutes and 12 minutes, and the side wall of the recessed portion of the pattern is upright
B: Scum is observed in a part of the recessed portion in the case of the development time of 8 minutes, but no scum is generated in the case of the development time of 12 minutes, and the side wall of the recessed portion of the pattern is upright
C: Scum is generated in both the cases of the development time of 8 minutes and 12 minutes, and/or the side wall of the recessed portion of the pattern is not upright

As the developer for a semiconductor, the aqueous semiconductor alkali solution is preferably evaluated as A, and even the aqueous semiconductor alkali solution evaluated as B can be used under appropriate conditions.

6) Etching Test

100 mL of the aqueous alkali solution for semiconductors was prepared and heated to 40°C, and then a silicon single crystal substrate (silicon 100 plane) having a size of 2 × 2 cm was immersed therein for 10 minutes. An etching amount was determined from the mass change before and after etching, and the etching amount was divided by the etching time to determine a silicon etching rate.

The obtained etching rate was evaluated based on the following criteria. The results are shown in Table 1.

A: Etching rate of 50 nm/min or more
B: Etching rate of 10 nm/min or more and less than 50 nm/min
C: Etching rate of 1 nm/min or more and less than 10 nm/min
D: Etching rate of less than 1 nm/min

As a semiconductor etching liquid, when the aqueous semiconductor alkali solution is evaluated as A to C, it can be used as the semiconductor etching liquid, and is preferably evaluated as A to B, and more preferably evaluated as A.

For the etched silicon substrate, the surface of the etched silicon substrate was observed with a field emission scanning electron microscope (JSM-7800F Prime, available from JEOL Ltd.) to confirm the presence or absence of surface roughness, and evaluation was performed in accordance with the following criteria. The surface roughness is ranked as A to D in ascending order, and all of the evaluations A to C are acceptable levels, preferable levels are the

evaluations A and B, and a more preferable level is the evaluation A.

A: No surface roughness is observed

B: Surface roughness is slightly observed (surface roughness is less than 30% of the entire surface)

C: Roughness is observed on the entire surface (surface roughness is from 30 to 100% of the entire surface)

D: Roughness is observed on the entire surface and the roughness is deep (unevenness larger than 1 × 1 μm is present)

[Table 1-1]

| | Quaternary ammonium hydroxide | | Quaternary ammonium hydroxide | | Surfactant | | Hydroxide ion |
|---|---|---|---|---|---|---|---|
| | Liquid type | mass % | Liquid type | mass % | Type | mass ppm | mass% |
| Example 1 | ETMAH | 2.7 | | | | | 0.44 |
| Example 2 | ETMAH | 7.3 | | | | | 1.18 |
| Example 3 | ETMAH | 2.7 | | | | | 0.44 |
| Example 4 | PTMAH | 3.1 | | | | | 0.44 |
| Example 5 | BTMAH | 3.5 | | | | | 0.44 |
| Example 6 | TEAH | 3.8 | | | | | 0.44 |
| Example 7 | TPAH | 5.3 | | | | | 0.44 |
| Example 8 | TBAH | 6.8 | | | | | 0.44 |
| Example 9 | TBAH | 9.7 | | | | | 0.64 |
| Example 10 | HTMAH | 8.3 | | | | | 0.44 |
| Example 11 | DEDMAH | 3.1 | | | | | 0.44 |
| Example 12 | ETMAH | 2 | PTMAH | 1 | | | 0.47 |
| Example 13 | ETMAH | 1 | HTMAH | 5 | | | 0.43 |
| Example 14 | ETMAH | 2.7 | | | SURFYNOL 465 | 20 | 0.44 |
| Example 15 | PTMAH | 3.1 | | | SURFYNOL 465 | 20 | 0.44 |
| Example 16 | BTMAH | 3.5 | | | SURFYNOL 465 | 20 | 0.44 |
| Comparative Example 1 | TMAH | 2.4 | | | | | 0.44 |
| Comparative Example 2 | TMAH | 2.4 | | | SURFYNOL 465 | 20 | 0.44 |

[Table 1-2]

| | Water | Halide ion | | Acute oral toxicity | Ecotoxicity (acute) | Development characteristics | Halide ion/hydroxide ion |
|---|---|---|---|---|---|---|---|
| | mass% | Type | mass ppm | | | | part by mass |
| Example 1 | 97.3 | Cl | 0.03 | B | A | A | 0.0000069 |
| Example 2 | 92.7 | Cl | 0.1 | B | A | A | 0.0000085 |
| Example 3 | 97.3 | Cl | 210 | B | A | B | 0.0480933 |
| Example 4 | 96.9 | Cl | 0.5 | B | A | A | 0.0001130 |
| Example 5 | 96.5 | Cl | 0.3 | B | A | A | 0.0000682 |
| Example 6 | 96.2 | Cl | 4 | A | A | A | 0.0009113 |
| Example 7 | 94.7 | Br | 5 | A | A | A | 0.0011279 |
| Example 8 | 93.2 | Br | 0.2 | A | A | A | 0.0000455 |
| Example 9 | 90.3 | Br | 0.3 | A | A | A | 0.0000472 |

(continued)

| | Water | Halide ion | | Acute oral toxicity | Ecotoxicity (acute) | Development characteristics | Halide ion/hydroxide ion |
|---|---|---|---|---|---|---|---|
| | mass% | Type | mass ppm | | | | part by mass |
| Example 10 | 91.7 | Cl | 13 | A | C | A | 0.0029465 |
| Example 11 | 96.9 | Cl | 11 | B | A | A | 0.0024868 |
| Example 12 | 97 | Cl | 0.1 | B | A | A | 0.0000215 |
| Example 13 | 94 | Cl | 9 | A | C | A | 0.0021052 |
| Example 14 | 97.3 | Cl | 0.03 | B | A | A | 0.0000068 |
| Example 15 | 96.9 | Cl | 0.5 | B | A | A | 0.0001136 |
| Example 16 | 96.5 | Cl | 0.3 | B | A | A | 0.0000682 |
| Comparative Example 1 | 97.6 | Cl | 0.1 | C | C | A | 0.0000227 |
| Comparative Example 2 | 97.6 | Cl | 0.1 | C | C | A | 0.0000227 |

[Table 2]

| | Quaternary ammonium hydroxide | | Quaternary ammonium hydroxide | | Hydroxide ion | Water | Halide ion | | Etching characteristics | |
|---|---|---|---|---|---|---|---|---|---|---|
| | Liquid type | mass% | Liquid type | mass% | mass% | mass% | Type | mass ppm | Rate | Surface roughness |
| Example 1 | ETMAH | 2.7 | | | 0.44 | 97.3 | Cl | 0.03 | A | A |
| Example 2 | ETMAH | 7.3 | | | 1.18 | 92.7 | Cl | 0.1 | A | A |
| Example 3 | ETMAH | 2.7 | | | 0.44 | 97.3 | Cl | 210 | A | C |
| Example 4 | PTMAH | 3.1 | | | 0.44 | 96.9 | Cl | 0.5 | A | A |
| Example 5 | BTMAH | 3.5 | | | 0.44 | 96.5 | Cl | 0.3 | A | A |
| Example 6 | TEAH | 3.8 | | | 0.44 | 96.2 | Cl | 4 | A | B |
| Example 7 | TPAH | 5.3 | | | 0.44 | 94.7 | Br | 5 | B | B |
| Example 8 | TBAH | 6.8 | | | 0.44 | 93.2 | Br | 0.2 | C | A |
| Example 9 | TBAH | 9.7 | | | 0.64 | 90.3 | Br | 0.3 | B | A |
| Example 10 | HTMAH | 8.3 | | | 0.44 | 91.7 | Cl | 13 | B | B |
| Example 11 | DEDMAH | 3.1 | | | 0.44 | 96.9 | Cl | 11 | A | B |
| Example 12 | ETMAH | 2 | PTMAH | 1 | 0.47 | 97 | Cl | 0.1 | A | A |

(continued)

| | Quaternary ammonium hydroxide | | Quaternary ammonium hydroxide | | Hydroxide ion | Water | Halide ion | | Etching characteristics | |
|---|---|---|---|---|---|---|---|---|---|---|
| | Liquid type | mass% | Liquid type | mass% | mass% | mass% | Type | mass ppm | Rate | Surface roughness |
| Example 13 | ETMAH | 1 | HTMAH | 5 | 0.43 | 94 | Cl | 9 | B | B |

<Preparation of Polishing Composition>

Colloidal silica (primary particle size: 35 nm, secondary particle size: 70 nm) as abrasive grains was mixed with and dispersed in water by a stirrer to prepare a slurry having a colloidal silica concentration of 4 mass%. 50 parts by mass of the slurry, 40 parts by mass of ultrapure water, and 10 parts by mass (7.5 parts by mass in each of Examples 20 and 21) of an aqueous alkali solution of a quaternary ammonium hydroxide compound shown in Table 3, which had been adjusted to 1.5 mass% in advance, were mixed to prepare a polishing composition having the composition shown in Table 3.

(Polishing)

A 4-inch p-type low-resistance silicon substrate (100 plane) was polished under the following conditions.

(Polishing Conditions)

Polisher: EJ-380IN available from Engis
Polishing pressure: 100 gf/cm$^2$
Polishing pad: SUBA-800, Nitta Haas Incorporated
Platen rotation number: 100 rpm
Supply amount of polishing composition: 200 ml/min
Polishing time: 20 minutes

In the evaluation of characteristics of the surface to be polished, masses before polishing and after polishing were measured, and the polishing rate was determined by the following equation.

Polishing rate = (substrate mass before polishing - substrate mass after polishing) ÷ polished area of substrate ÷ density ÷ polishing time

[Table 3]

| Example | Abrasive grain use amount (mass%) | Quaternary ammonium hydroxide compound | Quaternary ammonium hydroxide compound concentration (mass%) | Halide ion | Halide ion concentration (ppm) | pH | Polishing amount at 15-min polishing (μm) | Appearance confirmation | Oral acute toxicity | Ecotoxicity (acute) |
|---|---|---|---|---|---|---|---|---|---|---|
| 17 | 2 | ETMAH | 0.15 | Cl | 0.01 or less | 10.8 | 15 | △ | B | A |
| 18 | 2 | PTMAH | 0.15 | Cl | 0.02 | 10.7 | 13 | ○ | B | A |
| 19 | 2 | BTMAH | 0.15 | Cl | 0.01 | 10.6 | 11 | ○ | B | A |
| 20 | 2 | ETMAH | 0.075 | Cl | 0.01 | 10.5 | 14 | ○ | B | A |
| | | PTMAH | 0.075 | | | | | | | |
| 21 | 2 | ETMAH | 0.075 | Cl | 0.01 | 10.3 | 13 | ○ | B | A |
| | | BTMAH | 0.075 | | | | | | | |
| 22 | 2 | T BAH | 0.15 | Cl | 0.01 | 10.5 | 8 | ○ | A | A |
| 23 | 2 | TMAH | 0.15 | Cl | 0.01 or less | 10.8 | 16 | △ | C | C |

Appearance confirmation: Evaluation result by projection observation of surface
○: Good at the time of confirmation
Δ: A slight polishing mark can be confirmed at the time of confirmation.
×: A clear polishing scratch can be confirmed.

In a case where a silicon substrate is subjected to CMP processing using a polishing composition containing the aqueous alkali solution for semiconductors according to an embodiment of the present invention, the polishing composition has a practical polishing rate and a low halide ion concentration, and there is little concern about contamination of the polished object. TMAH shown in Experimental Example 23 has high toxicity and has a problem in handling. Among the low toxic quaternary ammonium ions, those having a quaternary ammonium structure in which only a part of the structure is different from the others achieved a good polishing rate.

Reference Signs List

1: Anode
2: Cathode
3: Power source
4: Anode chamber
5: Raw material chamber
6: Intermediate chamber
7: Cathode chamber
8: Anion-exchange membrane
9: Cation-exchange membrane

## Claims

1. An aqueous alkali solution for semiconductors, comprising the following (A) to (D):

   (A) a quaternary ammonium ion represented by Formula (1) below;
   (B) a halide ion;
   (C) a hydroxide ion; and
   (D) water

   [Chem 1]

   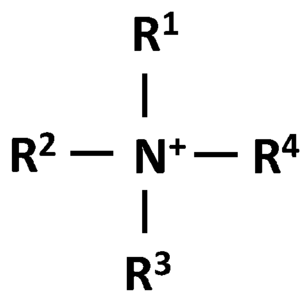

   (1)

   where $R^1$, $R^2$, $R^3$, and $R^4$ are each independently an alkyl group having carbon number from 1 to 16, with the proviso that the carbon number of one or more alkyl groups of $R^1$, $R^2$, $R^3$, and $R^4$ is from 2 to 16.

2. The aqueous alkali solution for semiconductors according to claim 1, wherein $R^1$, $R^2$, $R^3$, and $R^4$ in Formula (1) are not all the same alkyl group.

3. The aqueous alkali solution for semiconductors according to claim 1 or 2, wherein $R^1$, $R^2$, and $R^3$ in Formula (1) are methyl groups, and $R^4$ in Formula (1) is an alkyl group having carbon number from 2 to 16.

4. The aqueous alkali solution for semiconductors according to any one of claims 1 to 3, wherein the halide ion (B) is a chloride ion or a bromide ion.

5. The aqueous alkali solution for semiconductors according to any one of claims 1 to 4, wherein a part by mass of the halide ion is from 0.0000001 to 0.01 parts by mass when a mass of the hydroxide ion in the aqueous alkali solution for

semiconductors is 1 part by mass.

**6.** The aqueous alkali solution for semiconductors according to any one of claims 1 to 5, wherein an LD50 value converted on the basis that a hydroxide of the quaternary ammonium ion is taken as 100 mass%, in a toxicity test using a rat based on an OECD TG420 acute oral toxicity test, is more than 50 mg/kg.

**7.** The aqueous alkali solution for semiconductors according to any one of claims 1 to 6, wherein an EC50 value converted on the basis that a hydroxide of the quaternary ammonium ion is taken as 100 mass%, in an OECD TG202 Daphnia sp. acute immobilization test, is more than 3 mg/L.

**8.** The aqueous alkali solution for semiconductors according to any one of claims 1 to 7, further comprising one or more compounds selected from the group consisting of an alcohol and an amine.

**9.** The aqueous alkali solution for semiconductors according to any one of claims 1 to 8, further comprising a surfactant, wherein a concentration of the surfactant in the aqueous alkali solution for semiconductors is less than 100 mass ppm.

**10.** A polishing composition comprising the aqueous alkali solution for semiconductors according to any one of claims 1 to 9 and an abrasive grain.

**11.** A method for using the aqueous alkali solution for semiconductors according to any one of claims 1 to 9 as a low toxic aqueous alkali solution for semiconductors.

**12.** A method for manufacturing the aqueous alkali solution for semiconductors according to any one of claims 1 to 7, the method comprising an electrolysis step of electrolyzing an aqueous quaternary ammonium halide solution containing the following (A), (B), and (D):

(A) a quaternary ammonium ion represented by Formula (1) below;
(B) a halide ion; and
(D) water

[Chem 2]

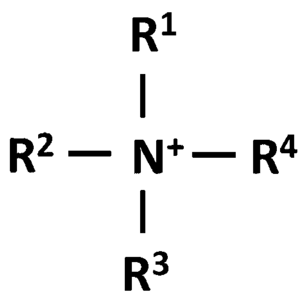

(1)

where $R^1$, $R^2$, $R^3$, and $R^4$ are each independently an alkyl group having carbon number from 1 to 16, with the proviso that the carbon number of one or more alkyl groups of $R^1$, $R^2$, $R^3$, and $R^4$ is from 2 to 16.

**13.** The method for manufacturing the aqueous alkali solution for semiconductors according to claim 12, the method further comprising a preparation step of preparing the aqueous quaternary ammonium halide solution before the electrolysis step, wherein
the preparation step is a step of reacting a trialkylamine with an alkyl halide in ultrapure water to yield the aqueous quaternary ammonium halide solution.

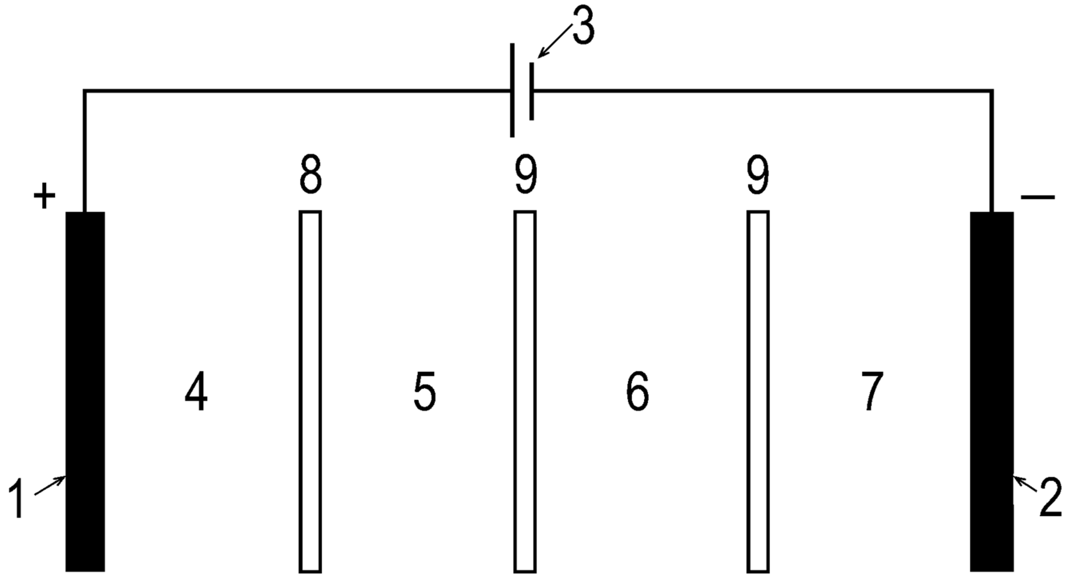


FIG.1

# INTERNATIONAL SEARCH REPORT

International application No.
**PCT/JP2024/031289**

## A. CLASSIFICATION OF SUBJECT MATTER

***G03F 7/32***(2006.01)i; ***C07C 211/63***(2006.01)i; ***G03F 7/40***(2006.01)i; ***H01L 21/027***(2006.01)i; ***H01L 21/304***(2006.01)i; ***H01L 21/306***(2006.01)i; ***H01L 21/308***(2006.01)i
FI: G03F7/32; C07C211/63; G03F7/40 521; H01L21/30 569E; H01L21/304 622D; H01L21/304 647A; H01L21/304 647B; H01L21/306 B; H01L21/308 B

According to International Patent Classification (IPC) or to both national classification and IPC

## B. FIELDS SEARCHED

Minimum documentation searched (classification system followed by classification symbols)

G03F7/32; C07C211/63; G03F7/40; H01L21/027; H01L21/304; H01L21/306; H01L21/308

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

## C. DOCUMENTS CONSIDERED TO BE RELEVANT

| Category* | Citation of document, with indication, where appropriate, of the relevant passages | Relevant to claim No. |
|---|---|---|
| X | JP 2021-116236 A (TOKUYAMA CORPORATION) 10 August 2021 (2021-08-10) paragraphs [0021], [0038], examples | 1-8, 11-13 |
| Y | | 9-10 |
| X | WO 98/003466 A1 (TOKUYAMA CORPORATION) 29 January 1998 (1998-01-29) claims, examples | 1, 4-7, 11-13 |
| Y | | 9-10 |
| A | | 2-3, 8 |
| Y | JP 2023-076385 A (FUJIFILM CORPORATION) 01 June 2023 (2023-06-01) paragraphs [0555], [0556] | 9-10 |

☐ Further documents are listed in the continuation of Box C.
☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **30 October 2024** | **12 November 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2024/031289**

| Patent document cited in search report | Publication date (day/month/year) | Patent family member(s) | Publication date (day/month/year) |
|---|---|---|---|
| JP 2021-116236 A | 10 August 2021 | (Family: none) | |
| WO 98/003466 A1 | 29 January 1998 | US 5929280 A<br>claims, examples<br>EP 860425 A1<br>TW 432029 B<br>KR 10-2000-0064258 A | |
| JP 2023-076385 A | 01 June 2023 | CN 116149134 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP H04226466 A